# EUROPEAN PATENT APPLICATION

(11) **EP 4 779 685 A1**
(43) Date of publication of application: **22.07.2026**
(21) Application number: 25152563.0
(22) Date of filing: 17.01.2025
(51) Int. Cl.: H01L 21/67, H01L 21/68

(54) **APPARATUS FOR JOINING SUBSTRATES AND METHODS THEREFOR**

(71) Applicant: ASML Netherlands B.V., 5500 AH Veldhoven (NL)
(72) Inventor: BEUKMAN, Arjan Johannes Anton, 5500 AH Veldhoven (NL); DEN BOEF, Arie Jeffrey, 5500 AH Veldhoven (NL); GOUTEUX, Louise Karina Laurie, 5500 AH Veldhoven (NL); RENKENS, Michael Jozefa Mathijs, 5500 AH Veldhoven (NL); TUKKER, Teunis Willem, 5500 AH Veldhoven (NL); ZIJP, Ferry, 5500 AH Veldhoven (NL)
(74) Representative: ASML Netherlands B.V.

(57) **Abstract**

A joining apparatus for joining a first substrate to a second substrate. The apparatus comprising a stage and a support structure. The stage is for holding the first substrate. The support structure for supporting the second substrate. The stage comprises a stage mark and an optical system for projecting an stage mark image.

## Description

### TECHNICAL FIELD

The present disclosure relates generally to an apparatus configured to join a first substrate and a second substrate, and methods for the apparatus.

### BACKGROUND

In manufacturing processes of integrated circuits (ICs), multiple substrates (which may be finished or unfinished ICs, e.g., whole wafers, diced wafers, partially diced wafers, chips, die, etc.) may be placed in contact, stacked, bonded, or otherwise joined (e.g., to heterogeneous or homogeneous devices) at various points in the fabrication process. Heterogeneous integration, e.g., the integration of different circuits or other patterned devices, may rely upon joining of specific portions (for example, conductive contact elements) of multiple substrates. These specific portions may be aligned in three-dimensional space to ensure functional connectivity.

Alignment of the substrates, which may each have multiple fabrication layers, different critical dimensions, different nodes, packaging, etc., may require different techniques than those used for lithography during fabrication. As the physical sizes of IC components continue to shrink, and their structures continue to become more complex, accuracy in integration is becoming more important.

Where two or more substrates (which may be referred to as donor substrates) are to be joined to another substrate (which may be referred to as the acceptor substrate). It is often desirable that the donor substrates be placed as close together as possible on the acceptor substrate. If a stage is used to hold a donor substrate and place it on the acceptor substrate then the stage must be constructed so that no part of it interferes with a donor substrate that has already been attached to the acceptor substrate. This requirement may impose limitations on the design of the stage that are difficult to meet.

### SUMMARY

It is an aim of the invention to provide a joining apparatus capable of placing multiple donor substrates on an acceptor substrate with high accuracy and minimum space between adjacent donor substrates.

According to an embodiment, there is provided a joining apparatus for joining a first substrate to a second substrate, the apparatus comprising:
a stage for holding the first substrate; and
a support structure for supporting the second substrate;
wherein the stage comprises a stage mark and an optical system for projecting an stage mark image.

According to an embodiment, there is provided a stage for a joining apparatus for joining a first substrate to a second substrate, the stage configured to hold the first substrate and comprising
a stage mark and an optical system for projecting an stage mark image.

According to an embodiment, there is provided an alignment method in an apparatus configured to join a first substrate and a second substrate, wherein the apparatus comprises a stage for supporting the first substrate and a support structure for supporting the second substrate, the method comprising:
projecting a stage mark image to a location substantially coplanar with a joining surface of the first substrate; and
measuring the relative positions of the stage mark image and one or more substrate marks provided on the first substrate.

According to an embodiment, there is provided a calibration method in an apparatus configured to join a first substrate and a second substrate, wherein the apparatus comprises a stage for supporting the first substrate and a support structure for supporting the second substrate, the method comprising:
projecting a stage mark image to a location substantially coplanar with a joining surface of the first substrate; and
detecting the stage mark image using an optical sensor on the substrate support.

According to an embodiment, there is provided a joining method for joining a first substrate and a second substrate using an apparatus comprising a stage for supporting the first substrate and a support structure for supporting the second substrate, the method comprising
aligning the first substrate to the stage using the aligning method described above;
determining the relative position of the stage mark image and the support structure using the calibration method described above; and
positioning the stage and/or the support structure during a joining process based on results of the aligning and determining.

### BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts. The accompanying schematic drawings include the following.
Figures 1A-1D are schematic diagrams illustrating an exemplary die bonding method.
Figure 2 is a schematic diagram illustrating a bonding tool.
Figure 3 is a schematic diagram illustrating a method for aligning a donor substrate to an acceptor substrate.
Figure 4 is a schematic diagram illustrating a problem addressed by the invention.
Figure 5 is a schematic diagram illustrating an arrangement of an embodiment of the invention.
Figure 6 is a schematic diagram explaining an alignment method in an embodiment of the invention.
Figure 7 is a schematic diagram of an optical system according to an embodiment of the invention.
Figure 8 is a schematic diagram of another optical system of an embodiment of the invention.
Figure 9 is a schematic diagram of another optical system of an embodiment of the invention.
Figure 10 is a schematic diagram of a holographic optical system of an embodiment of the invention.
Figure 11 is a schematic diagram of part of another embodiment of the invention.
Figure 12 is a schematic diagram of coupling illumination radiation in an embodiment of the invention.
Figure 13 is a schematic diagram of another arrangement for coupling illumination radiation in an embodiment of the invention.
Figure 14 is a schematic diagram of another arrangement for coupling illumination radiation in an embodiment of the invention.

### DETAILED DESCRIPTION

Embodiments of the present disclosure are described in detail with reference to the drawings, which are provided as illustrative examples of the disclosure so as to enable those skilled in the art to practice the disclosure. Notably, the figures and examples below are not meant to limit the scope of the present disclosure to a single embodiment, but other embodiments are possible by way of interchange of some or all of the described or illustrated elements. Moreover, where certain elements of the present disclosure can be partially or fully implemented using known components, only those portions of such known components that are necessary for an understanding of the present disclosure will be described, and detailed descriptions of other portions of such known components will be omitted so as not to obscure the disclosure.

Embodiments described as being implemented in software should not be limited thereto, but can include embodiments implemented in hardware, or combinations of software and hardware, and vice-versa, as will be apparent to those skilled in the art, unless otherwise specified herein. In the present specification, an embodiment showing a singular component should not be considered limiting; rather, the disclosure is intended to encompass other embodiments including a plurality of the same component, and vice-versa, unless explicitly stated otherwise herein. Moreover, applicants do not intend for any term in the specification or claims to be ascribed an uncommon or special meaning unless explicitly set forth as such. Further, the present disclosure encompasses present and future known equivalents to the known components referred to herein by way of illustration.

Although specific reference may be made in this text to the manufacture of ICs, it should be explicitly understood that the description herein has many other possible applications. For example, it may be employed in the manufacture of integrated optical systems, guidance and detection patterns for magnetic domain memories, liquid-crystal display panels, thin-film magnetic heads, etc.

The skilled artisan will appreciate that, in the context of such alternative applications, any use of the terms "wafer" or "die" in this text should be each considered as interchangeable with the more general term "substrate". The term "wafer" may be used generally to refer to a large unit of manufacture (which may be the largest unit of manufacture), while the term "die" may be used to refer to a smaller unit of manufacture which may correspond to a lithography pattern, a portion of a lithography pattern, multiple lithography patterns, etc. A "die" may correspond to a portion of "wafer" - that is a "die" may be produced by dicing or otherwise dividing a "wafer". The term "die" should be considered as interchangeable with the term chip, chiplet, or other terms for IC divisions.

A patterning apparatus (for example, a lithographic apparatus) can comprise, or can form, one or more patterns, which may correspond to one or more die. The patterns can be generated utilizing CAD (computer-aided design) programs, based on a pattern or design layout, this process often being referred to as EDA (electronic design automation).

As used throughout this application "or", unless indicated otherwise, takes a non-exclusive meaning, e.g., encompassing both "and" and "or".

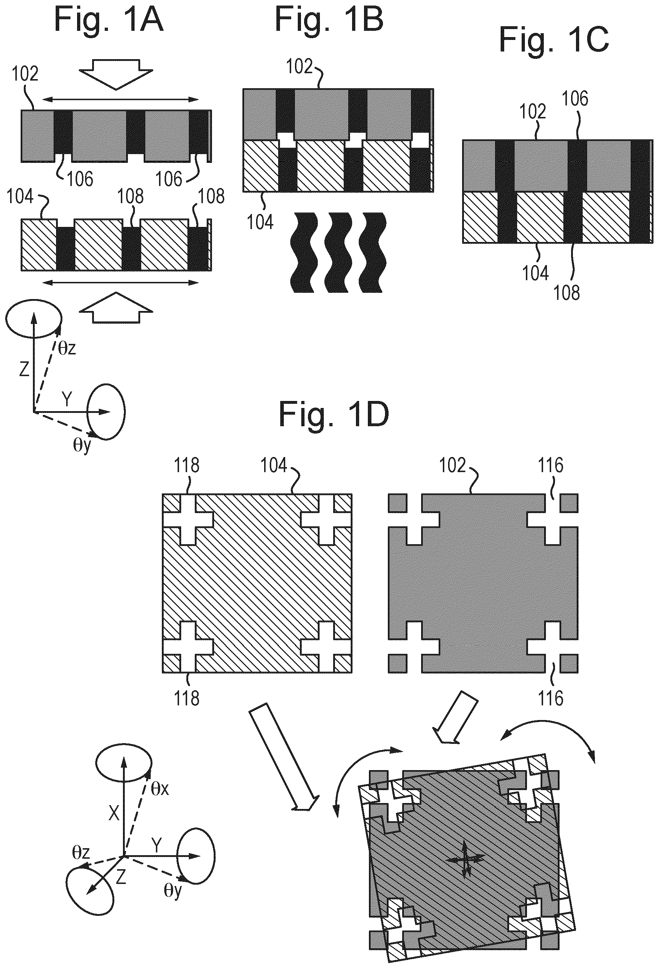

Reference is now made to Figures 1A-1D, which are schematic diagrams illustrating an exemplary die bonding method consistent with embodiments of the present disclosure. The die bonding method comprises bonding one die to another die. As will be appreciated, the bonding technique may be applied to bond any substrate (e.g. a whole wafer, a diced wafer, a partially-diced wafer, a chip, a die, etc.) to any other substrate (e.g. a whole wafer, a diced wafer, a partially-diced wafer, a chip, a die, etc.). For example, the bonding technique may be used to bond a die to another die, where the another die is a part of a wafer.

As shown in Figures 1A-1D, the exemplary die bonding method may involve a donor die 102 and a target die 104. Herein, the term "donor" and the term "target" are used for ease of description. It should be understood that the term "donor" and the term "target" are provided for reference and are relative and that elements described as corresponding to a "donor" can instead correspond to a "target" and vice versa.

The exemplary die bonding method is depicted in relation to a reference set of axes. The reference axes are provided for ease of description only and are not to be taken as limiting. Included methods and apparatuses can instead be described with reference to a different set of axes (e.g., cylindrical coordinates, polar coordinates, etc.), a different origin point (e.g., an origin point in the donor die, an origin point in the target, origin point in between the donor die and target, etc.), or a different orientation. The standard set of axes is chosen such that the fabrication plane of the die (i.e., a wafer surface) lies in the x-y plane and where the fabrication direction is parallel or antiparallel to the z-axis for both the donor die and target die.

The donor die 102 may have electrically active areas 106. The electrically active areas 106 may correspond to vias (e.g., through silicon vias (TSVs)), electrical contact lines, contact pads, packaging pads, or other electrically conductive areas. The donor die 102 may have one or more electrically inert areas (for example, electrically insulating areas or dielectric areas) outside of the electrically active areas 106. The electrically active areas 106 may be recessed (as shown) with respect to other surfaces of the donor die 102. The electrically active areas 106 may correspond to contacts (e.g., to source, to drain, to gate, etc.) to electrical devices within the donor die 102 (not shown). The target die 104, likewise, may have electrically active areas 108, which may have similar properties to the electrically active areas 106.

Figures 1A-1C depict a cross-sectional view of portions of the exemplary die bonding method. As shown in Figure 1A, the exemplary die bonding method may involve alignment of at least some of the electrically active areas 106 of the donor die 102 with at least some of the electrically active areas 108 of the target die 104. The exemplary die bonding method may involve bringing the donor die 102 into contact with the target die 104 while maintaining alignment between the electrically active areas 106 in the electrically active areas 108. As further shown in Figure 1A, the donor die 102 and the target die 104 may be brought together along the z-axis, while the position of the donor die 102 and/or the target die 104 may be adjusted in the x-y plane (e.g., perpendicular to the z-axis of approach). The alignment may be complicated by the multiple layers of the donor die 102 or the multiple layers of the target die 104, which may be optically opaque.

Upon bringing the donor die 102 into contact with the target die 104, an initial bond may be formed between the donor die 102 and the target die 104. The initial bond may be between dielectric areas of the donor die 102 and dielectric areas of the target die 104. The initial bond may comprise intermolecular forces, such as Van der Waal's forces and the like.

As shown in Figure 1B, the donor die 102 and the target die 104 may be annealed after contact. Annealing may be or include heat annealing, electrical annealing, electrostatic processes, etc. As shown in Figure 1C, annealing may cause physical or chemical changes in the electrically active areas 106 of the donor die 102 or in the electrically active areas 108 of the target die 104 which may cause physical contact or electrical contact between the electrically active areas 106 and the electrically active areas 108. Annealing may therefore produce electrical connectivity between elements of the donor die 102 and the target die 104 (e.g., integration). This electrical connectivity may occur even if the electrically active areas 106 and the electrically active areas 108 differ - for example, have different recessed depths, are made up of different materials, have different dimensions, etc.

Figure 1D depicts a plan view of an example die bonding method according to this disclosure. As shown in Figure 1D, the donor die 102 and the target die 104 may have alignment marks along the x-y plane to facilitate alignment of the die as a whole. Alignment marks in the x-y plane of die (e.g., alignment marks 116 on the donor die 102 or alignment marks 118 on the target die 104) may reduce the area available for circuitry. Alignment marks may be additively or subtractively fabricated, such as by etching or deposition in the z-direction.

Alignment marks (such as alignment marks used for alignment of one or more fabrication layer during lithography) used during fabrication of wafers may be placed in waste areas, such as areas between chips, which may then be destroyed (e.g., removed) during dicing. Dicing herein refers to mechanical separation of areas of a wafer (e.g., a unit of manufacture) into smaller areas (e.g., dies or chips) which may contain one or more units of operation (e.g., a logic device, a memory unit, etc.). Dicing may operate using any appropriate method - for example, scribing and breaking, mechanical sawing, laser cutting, etc. - and may destroy (e.g., grind to powder or otherwise render inoperable for circuitry placement) a non-zero linewidth portion of the wafer volume when separating die.

The electrically active areas 106 of the donor die 102 or the electrically active areas 108 of the target die 104 (not shown in Figure 1D) or other surface features may function as reference marks for alignment (e.g., alignment marks) of the donor die 102 and the target die 104. The donor die 102 and the target die 104 may be aligned in three dimensions before or during contact between the donor die 102 and the target die 104. For example, the donor die 102 or the target die 104 may be positioned or adjusted in the x-y plane as the donor die 102 in the target die 104 are contacted. The donor die 102 or the target die 104 may be positioned or adjusted by operation of a die actuator or other die-scale elements, such as by piezoelectric stepper elements, or by operation of a wafer chuck or other wafer-scale elements, such as by stepper elements.

The position of the donor die 102 or the target die 104 may be adjusted with respect to up to six degrees of freedom. For example, given an origin point at the center of the donor die 102, the donor die 102 may be adjusted by movement along the x-axis (e.g., in a positive or negative X direction), along the y-axis (e.g. in a positive or negative Y direction), along the z-axis (e.g., in a positive or negative Z direction). The donor die 102 may also be adjusted rotationally with respect to each of those axes - e.g., rotated with respect to the x-axis, rotated with respect to the y-axis, rotated with respect to the z-axis. That is, the donor die 102 may be adjusted by free rotation in space accounted for by six different types of movement (where the movements listed above are provided as examples but where the movements may be described by other axes).

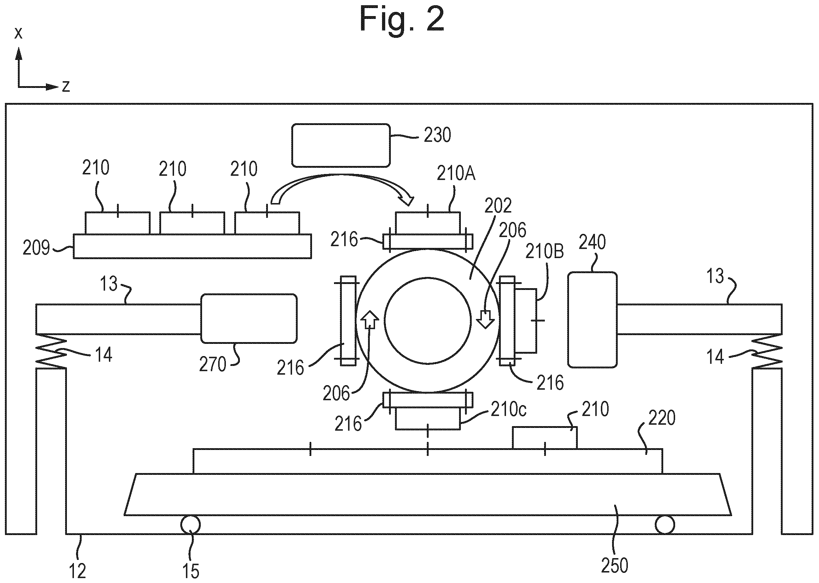

Figure 2 is a schematic diagram illustrating a bonding tool for the placement of donor substrates 210 onto an acceptor substrate 220 by a moveable stage 202. Figure 2 is described with reference to "donor" substrates 210 (e.g. donor substrates 210A-210C) and "acceptor" substrates 220, which are relative descriptors - a donor substrate may instead be an acceptor substrate, and vice-versa. The bonding tool depicted in Figure 2 may be configured to place any donor substrate (e.g. a whole wafer, a diced wafer, a partially-diced wafer, a chip, a die, etc.) onto any target substrate (e.g. a whole wafer, a diced wafer, a partially-diced wafer, a chip, a die, etc.). For example (and as depicted in Figure 2), the bonding tool may be configured to place a donor die 210 onto an acceptor wafer 220.

The acceptor substrate 220 may comprise one or more target portions. For example, the acceptor substrate 220 may comprise one or more target dies formed therein (prior to being diced/separated). The method/apparatus depicted in Figure 2 may be to place a donor die 210 onto a target die of the acceptor wafer 220. In the case that the acceptor wafer 220 comprises a plurality of target dies, the method may be repeated such that each donor die 210 is placed onto one of the plurality of target dies on the acceptor wafer 220.

The placing of a donor substrate 210 onto an acceptor substrate 220 may be a part of a bonding process comprising bonding the donor substrate 210 and the acceptor substrate 220 together. The bonding between the donor substrate 210 and the acceptor substrate 220 may be the same, or similar to, the bonding described with reference to Figure 1.

The stage 202 may be substantially circular in the x-z plane, with a longitudinal axis along the y-direction (e.g. the stage 202 may be substantially cylindrical in three dimensions). The stage 202 may instead have a different cross-sectional shape, such as square, hexagonal, etc. The stage 202 may have a symmetrical (e.g., as shown) cross-section with one or more axis of symmetry, or asymmetrical cross-sectional area (for example, an irregular polygon).

The stage 202 may comprise receiver portions 216. The receiver portions 216 each may be, or may comprise, a recess. The receiver portions 216 may each be configured to receive and/or accept and/or support and/or hold and/or clamp a donor substrate 210. The receiver portions 216 may each be configured to clamp a donor substrate 210 thereto using a vacuum clamping means and/or an electrostatic clamping means.

The placement of the receiver portions 216 may be symmetrical or asymmetrical around the cross-sectional area of the stage 202. The stage 202 may have a substantially symmetrical cross-section but have asymmetric placement of receiver portions 216. For example, the stage 202 may have a cross-section that is a regular hexagon but have receiver portions 216 placed asymmetrically along longitudinal faces.

The stage 202 may be a moveable stage, e.g. a rotatable stage. The stage 202 may be controllably moved (e.g. rotated) in a direction 206 about the longitudinal axis. The direction 206 is provided as an example. The stage 202 may instead be rotated in an opposite direction or any appropriate direction, translated along the x, y, or z direction or any combination thereof. The stage 202 may be operated in both rotational and translational modes, including sequentially or at the same time. For example, the stage 202 may move in the negative x-direction towards a support structure 250 while also rotating about the longitudinal axis. The stage 202 may move continuously or intermittently. For example, the stage 202 may rotate in the direction 206 and stop at four (or fewer or more) positions corresponding to operations in the placement of the donor substrate 210.

Example positions and operations will now be further discussed. These positions and operations are provided as examples only, and multiple operations may be performed at a single position, a position may not correspond to an operation (e.g., may correspond to a null operation), an operation may be performed at multiple positions (e.g., the operation may be performed multiple times or in steps divided between positions), etc. These positions and operations are described as happening in discrete positions (such as when movement of the stage 202 is substantially zero), but the positions may instead correspond to continuous (or quasi-continuous movement) or operations may occur while the stage 202 is moving in one or more directions (e.g., rotationally, translationally, etc.).

A first position, such as corresponding to the position depicted for the donor substrate 210A, may correspond to placement of a donor substrate 210A in a receiver portion 216 of the stage 202. The donor substrate 210A may be placed on the receiver portion 216 by a pick and place element 230. The pick and place element 230 may place the donor substrate 210A on the stage 202 on the receiver portion 216 based on alignment information, based on positional information of the stage 202, etc. The pick and place element 230 may place the donor substrate 210A on the support structure at a given position relative to the receiver portion 216. For example, the pick and place element 230 may center the donor substrate 210A relative to the receiver portion 216.

The second position, such as corresponding to the position depicted for the donor substrate 210B, may correspond to measurement of the position of the donor substrate 210B relative to the receiver portion 216 of the stage 202. The position (e.g., location) of the donor substrate 210B may be measured by a location measurement element 240. The location measurement element 240 may measure an actual position of the donor substrate 210B, in relative (such as relative to the receiver portion 216) or absolute terms (such as in distances from an origin point on the stage 202, on the location measurement element 240, etc.).

The location measurement element 240 may be a camera, e.g., a two-dimensional camera, two or more one-dimensional cameras, an optical camera, etc., or another measurement device. The location measurement element 240 may be made up of multiple location measurement elements, such as an in-plane measurement device which may measure locations in the y-z plane (relative to the reference axes) and an out-of-plane measurement device which may measure locations or distances in the x direction (relative to the reference axes). The location measurement element 240 may include one or more confocal microscopes, which may measure depth (or other distance). The location measurement element 240 may measure position, relative or absolute position, using overlay diffraction or other diffraction-based methods. The location measurement element 240 may operate in a scanning mode or from a fixed position relative to the stage 202.

Once the position of the donor substrate 210B is measured, the stage 202 may move (e.g., rotate in the direction 206), so that the donor substrate 210B occupies the position of the donor substrate 210C, which may be a third position of the stage 202. The third position of the support structure will now be described with reference to the donor substrate 210C.

The third position, such as corresponding to the position depicted for the donor substrate 210C, may correspond to placement of the donor substrate 210C on the acceptor substrate 220. The acceptor substrate 220 may comprise a target portion (e.g. a target die, as described above). The bonding tool may be configured to place the donor substrate 210C at the target portion of the acceptor substrate 220 by bringing the donor substrate 210C into contact with the target portion of the acceptor substrate 220. As the donor substrate 210C is brought into contact with the target portion of the acceptor substrate 220, initial bonding forces (e.g. Van der Waal's forces and the like) may be formed between the donor substrate 210C and the acceptor substrate 220.

The acceptor substrate 220 may be supported by the support structure 250. The donor substrate 210C may be brought into contact with the acceptor portion by motion of the stage 202 towards the support structure 250, motion of the support structure 250 towards the stage 202, or a combination thereof. Motion of the stage 202 towards the support structure 250 may comprise movement in the z-direction. Motion of the stage 202 towards the support structure 250 may comprise movement of the whole stage 202 towards the support structure 250. Motion of the stage 202 towards the support structure 250 may comprise movement of the receiver portion 216 in the third position towards the support structure 250 (i.e. movement of the receiver portion 216 in the third position relative to a main body of the stage 202). Motion of the stage 202 towards the support structure 250 may comprise a combination of movement of the whole stage 202 and movement of the receiver portion 216 in the third position relative to the main body of the stage 202. Motion of the support structure 250 towards the stage may comprise movement in the z-direction.

Once the donor substrate 210C is placed on the acceptor substrate 220, the stage 202 and the support structure 250 may operate (individually or in concert) to place at least one additional donor substrates on the acceptor substrate 220. For example, the stage 202 and the support structure 250 may move relative to one another in the x- or y-direction so that another part of the acceptor substrate 220 is proximate to the stage 202 (e.g. so that another target portion of the acceptor substrate 220 is aligned with the stage 202). The relative motion of the stage 202 and the support structure 250 may be caused by movement of the support structure 250 (e.g. by the positioning system for the support structure 250).

After placing the donor substrate 210C onto the acceptor substrate 220, the stage 202 may rotate to align the next donor substrate on the stage (i.e. the donor substrate 210B) with the acceptor substrate 210. Generally, the stage 202 may be rotatable to align different donor substrate 210 (and/or different receiver portions 216 of the plurality of receiver portions 216) with the acceptor substrate 220.

A direction of gravity is not depicted, but the placement of the donor substrate 210C on the acceptor substrate 220 may experience gravitation effects. For example, the placement of the donor substrate 210C on the acceptor substrate 220 may be encouraged by gravity (e.g., occur in the direction of gravity) or be retarded by gravity (e.g., occur opposite the direction of gravity). Gravitational effects may be balanced by clamps, suction, vacuum, and other forces.

The stage 202 may comprise an actuator (not shown). The actuator may be configured to cause the stage 202 to accept the donor substrates 210 from the pick & place element 230 and subsequently transport the donor substrates 210 to location measurement element 240 and finally place the donor substrates 210 on the acceptor substrate 220. The actuator may be configured to rotate the stage 202 in the manner described above.

The support structure 250 may be configured to move the acceptor substrate 220 with high accuracy. The bonding tool may comprise a base frame 212. As shown in Figure 2, the support structure 250 that supports the acceptor substrate 220 may be coupled to the base frame 212 by at least one bearing 215. The support structure 250 may comprise a plurality of stages that may be stacked relative to each other via a plurality of bearings.

For example, the support structure 250 may comprise a long stroke module for relatively coarse positioning of the acceptor substrate 220 over a longer distance, and a short stroke module for higher accuracy positioning of the acceptor substrate 220 over a shorter distance. The short stroke module may be stacked on the long stroke module. The short stroke module and the long stroke module may each be part of a positioning system configured to position the support structure 250 (and therefore to position the acceptor substrate 220 supported on the support structure 250) in the horizontal plane, i.e. in the x- and y-directions. The short stroke module and the long stroke module may each comprise one or more actuators configured to move the support structure 250 relative to the base frame 212. Thus, in general, the positioning system may comprise one or more actuators configured to move the support structure 250.

The positioning system may comprise one or more sensors configured to determine the position of the support structure. The one or more sensors may be interferometric sensors, as described in XXX, the entirety of which is hereby incorporated by reference.

As shown in Figure 2, the bonding tool may comprise a metrology frame 213. The metrology frame 213 may be referred to as an isolated frame. The metrology frame 213 may be isolated relative to the base frame 212. The bonding tool may comprise an isolator 214. The isolator 214 may be configured to substantially isolate the metrology frame 213 from the base frame 212. By isolating the metrology frame 213 from the base frame 212, vibrations of the base frame 212 may have less of an effect on the metrology frame 213.

A controller may be configured to control the stage 202 and the support structure 250 so as to accurately place a donor substrate 210 onto a target portion of the acceptor substrate 220. Alignment between the donor substrate 210 and the acceptor substrate 220 in the horizontal (x and y) directions is important. This is because, as described above, the donor substrate 210 and the acceptor substrate 220 each have electrically-active areas which must come into contact with each other for the combination of the donor substrate 210 and the acceptor substrate 220 to function as intended.

To accurately align the donor substrate 210 and the acceptor substrate 220, the position of the donor substrate 210 relative to the acceptor substrate 220 may be determined. The determination of the position of the donor substrate 210 relative to the acceptor substrate 220 may be direct, indirect, explicit or implicit. For example, the actual position of the donor substrate 210 relative to the acceptor substrate 220 itself may not be explicitly determined, but another parameter which is indicative of the position of the donor substrate 210 relative to the acceptor substrate 220 may be determined (and thus the position of the donor substrate 210 relative to the acceptor substrate 220 is determined indirectly/implicitly). The determination of the position of the donor substrate 210 relative to the acceptor substrate 220 may be may be done with use of alignment marks (e.g. like the alignment marks 118, 116 depicted in Figure 1) on the donor substrate 210 and the acceptor substrate 220.

Additionally or alternatively, the position of the donor substrate 210 relative to the acceptor substrate 220 may be determined based on determining the position of the stage 202 (e.g. the position of the receiver portion 216 in the third position) relative to the support structure 250. This may be possible because the position of the acceptor substrate 220 relative to the support structure 250 is accurately known and/or the position of the donor substrate 210 relative to the stage 202 (e.g. relative to the receiver portion 216) is accurately known. The position of the receiver portion 216 in the third portion relative to the stage 202 in general may be known and fixed (e.g. because the receiver portion 216 is fixedly coupled to a main body of the stage 202). Thus, knowledge of the position of the stage 202 relative to the support structure 250 may be equivalent to knowledge of the position of the receiver portion 216 in the third position relative to the support structure, and vice-versa.

The position of the acceptor substrate 220 relative to the support structure 250 may be known through a metrology process performed by a sensor, e.g. an alignment sensor. The position of the donor substrate 210 relative to the stage 202 (e.g. relative to the receiver portion 216) may be accurately known through measurements performed by the location measurement element 240, as described above.

The alignment sensor used to obtain the position of the acceptor substrate 220 relative to the support structure 250 may be known may be an interferometric sensor. The alignment sensor may be configured to determine a position of an alignment mark (e.g. a diffraction grating) on the acceptor substrate 220 relative to a reference mark (e.g. a diffraction grating) on the support structure 250. An example of an alignment sensor is described in EP1 372 040B1, the entirety of which is hereby incorporated by reference.

The alignment sensor may be disposed in a measurement station of the bonding tool (not shown). The measurement station may be separate and/or distinct from the bonding station of the bonding tool (i.e. the station depicted in Figure 2).

The bonding tool may comprise two support structures 250, each configured to support an acceptor substrate 220. The support structures 250 may be independently moveable. The support structures 250 may each be provided with a positioning system, such as the positioning system described above. Alternatively, the bonding tool may comprise a single positioning system which is configured to move the two support structures 250 independently. The bonding tool may be configured such that one support structure 250 can be positioned in the measurement station and the other support structure 250 can be positioned in the bonding station, simultaneously. Thus, preparatory measurement processes may be performed on one acceptor substrate 220 (in the measurement station) while bonding processes are performed on another acceptor substrate 220 (in the bonding station).

The position of the stage 202 (e.g. the position of the receiver portion 216 in the third position) relative to the support structure 250 may be determined by measuring the position of the stage 202 using one measurement system, and measuring the position of the support structure 250 using another, independent measurement system (e.g. the positioning system described above). The positions of the stage 202 and the support structure 250 may be measured in different coordinate systems, and/or with respect to different references.

For the bonding tool to be able to accurately place a donor substrate 210 at a target portion of the acceptor substrate 220, the relative position of the support structure 250 and the stage 220 may need to be accurately determined based on the measured position of the stage 202 and/or the measured position of the support structure 250 (specifically, in the x- and y-directions). In some embodiments, the position of the stage 202 in the x- and y-directions may be fixed, such that the determination of the position of the stage 202 relative to the support structure 250 in the x- and y-directions is based on the measurement of the position of the support structure 250 by the positioning system. Even where the position of the stage 202 in the x- and y-directions is fixed, the stage 202 may be able to rotate to align different receiver portions 216 with the acceptor substrate 220.

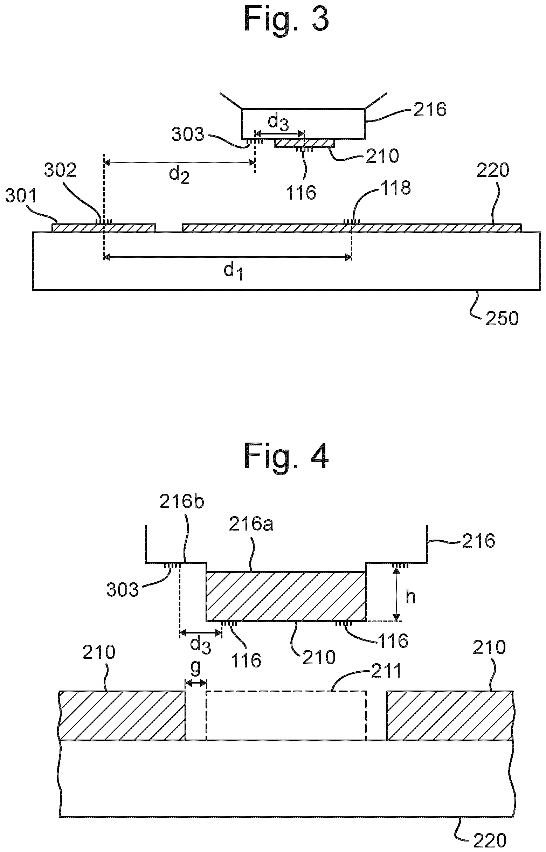

Figure 3 depicts schematically an arrangement for aligning a donor substrate 210 held by stage 216 to an acceptor substrate 220 held by support structure 250. A fiducial 301 is fixedly mounted to support structure 250 and carries a reference mark 302. The acceptor substrate 220 has an alignment mark 118. An alignment system is used to determine displacement d1 between reference mark 302 and alignment mark 118. A known alignment system such as referred to above may be used for this process which may involve positioning the reference mark 302 in the field of view of the alignment sensor, then moving substrate support 250 to position the alignment mark 118 in the field of view of the alignment centre whilst measuring the displacement of the substrate support 250. Similarly, displacement d3 between a stage mark 303 provided on stage 216 and an alignment mark 116 provided on substrate 210 can be determined by another alignment sensor or the same alignment sensor. Displacement d2 between reference mark 302 and stage mark 303 can also be determined by an alignment sensor or by another calibration technique which will be discussed further below. Knowing d1, d2 and d3, the relative position of the acceptor substrate 220 and donor substrate 210 can be determined and the donor substrate 210 can therefore be joined to the acceptor substrate 220 at a desired position with high accuracy.

All of reference marks 302, stage mark 303 and alignment marks 116, 118 may comprise two dimensional arrangements of gratings allowing for the displacements d1, d2 and d3 to be determined in two dimensions in a plane parallel to the surface of acceptor substrate 220. Any suitable alignment mark can be used.

Figure 4 illustrates an issue that arises when multiple donor substrates 210 are to be placed on a single acceptor substrate 220. It is often desirable to place multiple donor substrates on a single acceptor substrate as close together as possible, i.e. the gap g between a donor substrate 210 already joined to acceptor substrate 220 and the position 211 where a further donor substrate 210 is to be placed is desirably as small as possible. To be placed on the acceptor substrate, donor substrate 210 is held on a holding plane 216a. It is desirable that parts of the stage 216 to the sides of the holding plane 216a do not collide with or otherwise interfere with the already joined donor substrates 210 when a new donor substrate 210 is joined to the acceptor substrate 220. Thus, a side portion 216b of the stage 216 is recessed relative to the holding plane 216a. The side portion 216b includes the stage mark 303. This means there is a height difference h between the stage mark 303 and the alignment mark 116 that is provided on the donor substrate 210 held on the holding plane 216a.

Height difference h reduces the accuracy with which the displacement D3 between stage mark 303 and alignment mark 116 can be measured. This is because a conventional alignment sensor has depth of field much less than height difference h, which is greater than the thickness of a donor substrate 210. The height difference h means that to measure the displacement D3 with a standard alignment sensor, the alignment sensor or the stage 216 would need to be moved in the direction perpendicular to the support plane 216a as well as in directions parallel to the support plane 216a in order to determine the relative position of the stage mark 303 and alignment mark 116. The stage may not be configured to move in this way. Even if the stage were able to move in the direction perpendicular to the support plane 216a, there is a risk that in moving the stage and/or the alignment sensor in the direction perpendicular to the holding plane 216 there is an inadvertent and unmeasured movement in a direction parallel to the holding plane 216a. That would represent an inaccuracy in the measurement of displacement d3.

An alternative approach would be to increase the depth of field of the alignment sensor requires reduction of the numeric aperture (NA) of the alignment sensor and increasing the pitch of the gratings forming stage mark 303 and alignment mark 116. These changes would also reduce the accuracy by which the displacement D3 could be measured. Accordingly therefore, it is desirable to provide an arrangement that allows for accurate determination of the position of a donor substrate held on a stage and for that donor substrate to be positioned close to other donor substrates on an acceptor substrate.

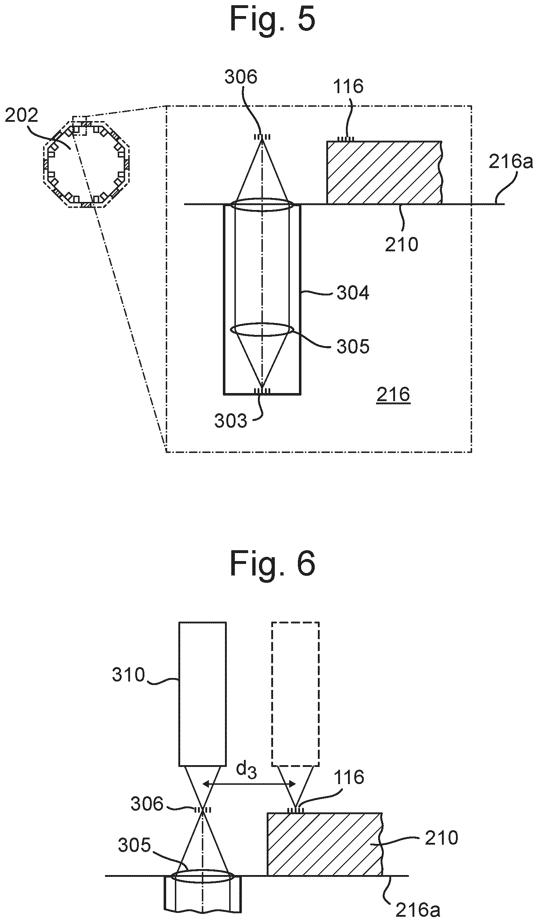

Figure 5 depicts an arrangement according to an embodiment of the invention in which a stage 216 for holding a donor substrate 210 has a stage mark 303 and an optical system 305 for projecting a stage mark image 306. Desirably, the stage mark 303 is located in a recess 304 behind (or below) holding plane 216a so that optical system 305 and mark 303 do not project above or in front of holding plane 216a. The stage mark 303 is spaced away from the holding plane 216a on the opposite side from where the donor substrate is held. Desirably, optical system 305 projects a stage mark image 306 in front or (or above) holding plane 216a. Desirably, stage mark image 306 is projected to a location that is coplanar with the upper surface of donor substrate 210 on which is provided alignment mark 116. This means that an alignment sensor can determine the relative position of stage mark 303 and alignment mark 116 via stage mark image 306 without requiring a large depth of field or a vertical movement.

Determination of the relative position of stage mark image 306 and alignment mark 116 is illustrated in Figure 6. The optical system 305 allows an alignment sensor 310 to "see" the stage mark 303 at the position of the stage mark image 306 which is coplanar with the alignment mark 116 provided on donor substrate 210. Therefore, the displacement d3 can be measured by moving the alignment sensor 310 and/or the stage 216 parallel to the holding plane 216a. As well as avoiding possible inaccuracies due to movement in a direction perpendicular to the holding plane 216a, it may be possible to reduce the range of motion of the stage 216 in the direction perpendicular to the holding plane 216a. The alignment sensor 310 need not have a large depth of field and gratings having a small pitch can be used for the stage mark 303 and the alignment sensor 116.

Desirably, the optical system 305 projects the stage mark image 306 to a height above the holding plane 216a that is equal to the thickness of a donor substrate 210. The distance between image 216 and holding plane 216a may be in the range of from about 0.2 mm to about 5 mm, desirably about 0.5 mm to about 1.5 mm. If the joining apparatus is to be used with donor substrates of different thicknesses, it may be desirable that the position of the stage mark image 306 relative to holding plane 216a is adjustable. Adjustment of the vertical position of stage mark image 306 can be achieved by adjusting the optical system 305 or by physically moving the optical system 305 and or stage mark 303. Adjusting the vertical position of stage mark image 306 may be actuated or manual. Alternatively or in addition, the position of the distal surface of the donor substrate relative to the holding plane 216a can be adjusted using a spacer.

Desirably, optical system 305 has a magnification substantially equal to 1. In this case, the stage mark 303 may be identical to the alignment mark 116 and can therefore be readily manufactured by conventional processes. However, the magnification of optical system 305 can be greater than or less than 1 with a corresponding change in the scale of stage mark 303. Having a different magnification of optical system 305 may allow for optical system 305 to be made smaller and/or increase the distance of stage mark image 306 away from holding plane 216a. It may be preferable to have magnification smaller than 1 rather than greater than 1 since a magnification greater than 1 would require the stage mark 303 to be made with a smaller pitch, which may be difficult.

The optical system 305 and stage mark 303 can be provided in a holder which is then inserted into a recess 304 provided in stage 216. The optical system and stage mark can be accurately manufactured and set in a fixed relationship by the holder.

It will be appreciated that stage 216 may have two or more stage marks 303 and respective optical systems 305. This can allow the rotational position of donor substrate 210 to also be determined. A joining apparatus having multiple stages 206, e.g. with a rotating drum 202, may have one or more stage marks 303 and optical systems 305 per stage.

Various different forms of optical system can be used as optical system 305. Optical system 305 may comprise a pair of spherical lenses in a 4f arrangement as depicted in Figure 5. Aberrations are sufficiently low that aspheric lenses are not required, reducing the cost of goods.

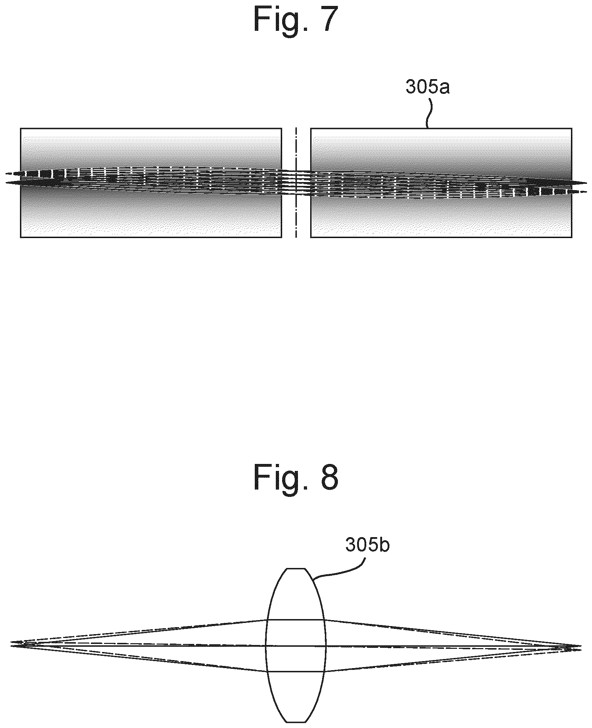

Optical system 305 may comprise a pair of gradient index lenses 305a as depicted in Figure 7. A gradient index lens has a refractive index that varies radially, i.e. with distance from the optical axis. A gradient index lens can be formed as a cylinder which is easily mounted in a holder and can be very stable. A pair of gradient index lenses 305a may be arranged to form a 4f system which is aberration free for the on axis point and has sufficiently low aberrations across a field of view sufficient for a stage mark 303.

It is also possible to use a single aspheric lens 305b as the optical system 305, as depicted in Figure 8. Having a single lens may enable the optical system to be made smaller.

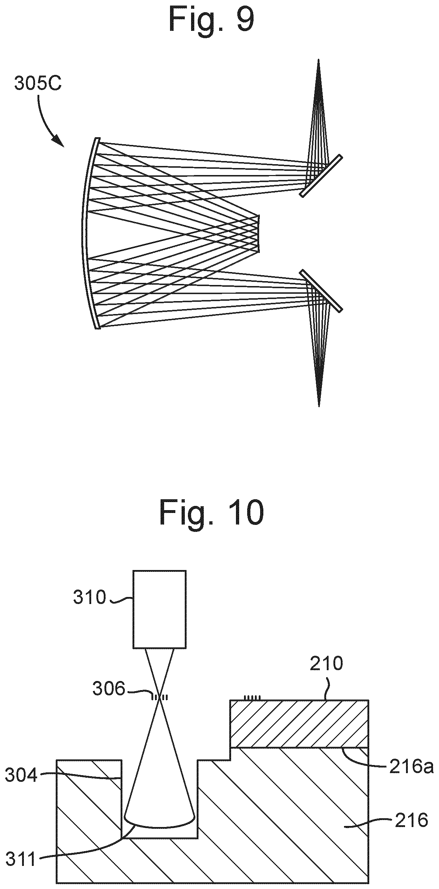

Optical system 305 may comprise a mirror system 305c based on the Offner relay as depicted in Figure 9. Mirror system 305c comprises two flat mirrors and two spherical mirrors. Mirror system 305c is achromatic so that multiple wavelengths can be used in the alignment sensor, potentially increasing accuracy. This arrangement also has a large field of view and very low aberrations. A mirror system 305c may however be somewhat larger than an optical system based on refractive lenses.

A further alternative arrangement is depicted in Figure 10. Here, the stage mark 303 is formed as a hologram on a convex mirror 311. The stage mark image 306 is formed at the centre of curvature of the convex mirror. The convex mirror 311 is located in a recess 304 in stage 216. Alignment sensor 310 emits light towards 311 where it is perturbed in phase by the hologram just as if there were a physical mark at the location of the stage mark image 306. Since this arrangement comprises a single optical element, the convex mirror 311, alignment is greatly simplified. The hologram can be fabricated by coating the mirror with a photosensitive material, e.g. a resist. A mark, e.g. a grating, is placed in the centre of the curvature of the mirror and illuminated with radiation as emitted by the alignment sensor. An additional phase matched reference beam is directed onto the mirror to interfere with the light from the mark so as to form an interference pattern. The radiation sensitive material is altered by the interference pattern and developed.

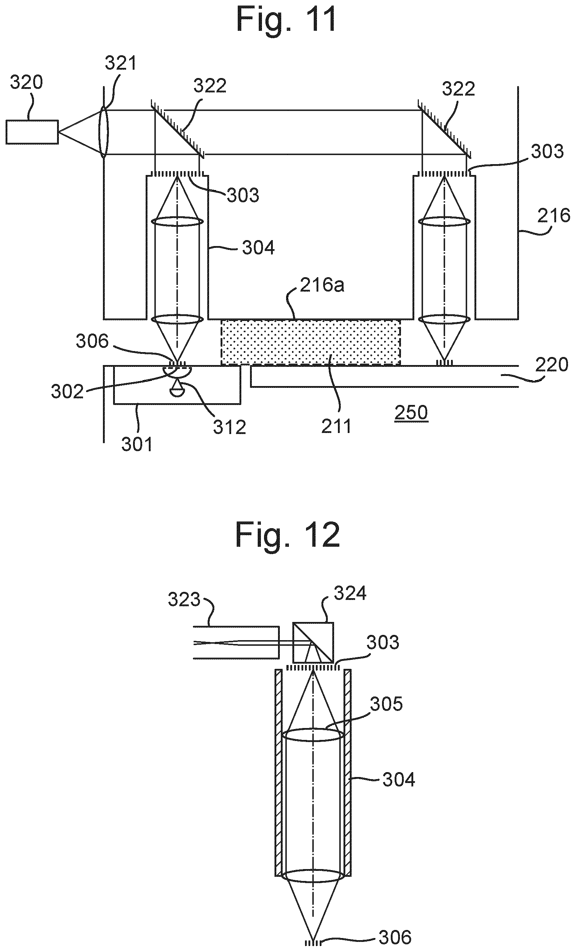

A calibration method to determine the positional relationship between stage mark image 306 and reference mark 302 using an optical sensor provided on the support structure will now be described with reference to Figure 11. Reference mark 302 comprises a grating formed of opaque and transmissive parts corresponding to the stage mark image 306. Behind the reference mark 302 is an optical sensor 312, e.g. a photodiode. The support structure 250 is scanned so that the reference mark 302 moves through stage mark image 306. The signal output by optical sensor 312 fluctuates as the bright parts of the stage mark image 306 come into and move out of alignment with the transmissive parts of reference mark 302. It is possible to determine by analysis of the signal output by optical sensor 312 when the reference mark 302 and stage mark image 306 are best aligned, i.e. they are coincident or have a relative displacement of zero. This arrangement is known in lithography as a transmission image sensor because it senses or detects the position of the stage mark image. A variant known as a reflection image sensor and other arrangements to detect the position of an image can also be used. In Figure 11 the location where a donor substrate would be if it where held by the holding plane 216a is denoted by 211 but desirable no donor substrate is present during the calibration method to avoid damage to the support structure 250 or fiducial 310.

For the calibration method, the stage mark 303 is illuminated by illuminator 320, e.g. a laser, laser diode or LED. Stage mark 303 may comprise a grating formed of opaque and transmissive parts and be illuminated from behind as depicted in Figure 11. Alternatively or in addition, stage mark 303 may comprise a grating formed of reflective and absorbent parts and be illuminated from in front. Stage mark 303 may be a phase grating that is illuminated form behind if transmissive or in front if reflective. Light from illuminator 320 may be coupled into a light guide formed in stage 216 by coupling lens 321 and directed to illuminate stage mark 303 by reflector 322. In the case where there are multiple stage marks 303, reflector(s) 322 may be partially reflective.

Alternatively, light from illuminator 320 may be guided to stage mark 303 by an optical fibre 323. A prism 324 may be used to direct light to evenly illuminate stage mark 303. Such an arrangement is depicted in Figure 12.

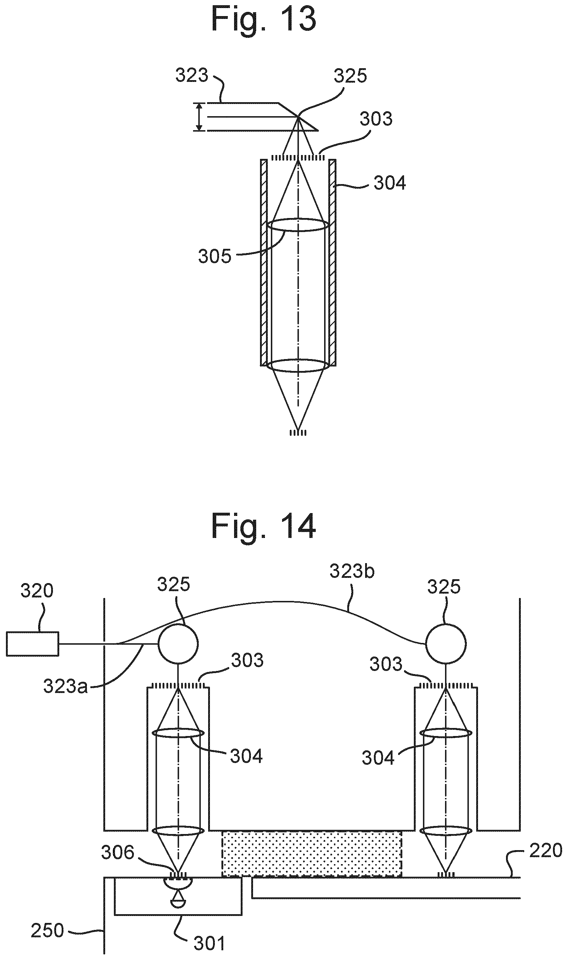

An alternative to prism 324 is to use a fibre 323 having an angle cleaved end 325 as depicted in Figure 13. Use of fibres to couple illumination light to the stage marks 303 is advantageous where there are multiple stage marks 303 in a stage and other components of the stage, e.g. vacuum components to clamp the donor substrate to holding plane 216a, prevent a direct light path to all stage marks 303. Multiple fibres 323a, 323b and a fibre splitter may be used to direct illumination light to the desired locations. Optical fibre 232 may be a single mode fibre or a multi-mode fibre.

Light sources adjacent the or each stage mark may also be used. However, a light source remote from stage 216 avoids the need for electrical connections to the stage, which may be difficult if the stage 216 is provided on a rotatable drum 202. Each stage 216 is provided with a window to receive a beam of light from illuminator 320 when the stage 216 is located at the calibration position.

The methods of the present invention may be performed by computer systems comprising one or more computers. A computer used to implement the invention may comprise one or more processors, including general purpose CPUs, graphical processing units (GPUs), tensor processing units (TPU) or other specialised processors. A computer used to implement the invention may be physical or virtual. A computer used to implement the invention may be a server, a client or a workstation. Multiple computers used to implement the invention may be distributed and interconnected via a network such as a local area network (LAN) or wide area network (WAN). Individual steps of the method may be carried out by a computer system but not necessarily the same computer system. Results of a method of the invention may be displayed to a user or stored in any suitable storage medium. The present invention may be embodied in a non-transitory computer-readable storage medium that stores instructions to carry out a method of the invention. Any suitable programming language may be used to implement the invention. The present invention may be embodied in a computer system comprising one or more processors and memory or storage storing instructions to carry out a method of the invention.

Further embodiments are described in the subsequent list of numbered clauses:
1. A joining apparatus for joining a first substrate to a second substrate, the apparatus comprising:
   a stage for holding the first substrate; and
   a support structure for supporting the second substrate;
   wherein the stage comprises a stage mark and an optical system for projecting an stage mark image.
2. An apparatus according to clause 1 wherein:
   the stage defines a holding plane on which the first substrate is supported;
   the mark is recessed behind the holding plane; and
   the optical system is configured to project the stage mark image to a position in front of the holding plane.
3. An apparatus according to clause 2 wherein the distance between the holding plane and the stage mark image is in the range of from about 0.2 mm to about 5 mm, desirably about 0.5 mm to about 1.5 mm.
4. An apparatus according to clause 1, 2 or 3 further comprising an alignment system configured to measure the relative positions of the stage mark image and one or more substrate marks provided on the first substrate.
5. An apparatus according to clause 1, 2, 3 or 4 further comprising an optical sensor provided on the support structure and configured to detect the stage mark image.
6. An apparatus according to any preceding clause wherein the optical system has a magnification substantially equal to 1.
7. An apparatus according to any preceding clause wherein the optical system is accommodated in the stage behind the holding plane.
8. An apparatus according to any preceding clause wherein the optical system comprises an adjustment mechanism configured to adjust the position of the stage mark image.
9. An apparatus according to any preceding clause wherein the optical system is selected from the group consisting of:
   a. a pair of positive lenses;
   b. a single positive lens;
   c. a pair of gradient index lenses;
   d. an Offner relay mirror system.
10. An apparatus according to any one of clauses 1 to 9 wherein the stage mark and the optical system are formed by a reflective hologram.
11. An apparatus according to any one of clauses 1 to 9 wherein the stage mark comprises an arrangement of transmissive parts and reflective parts.
12. An apparatus according to any preceding clause further comprising an illuminator configured to illuminate the stage mark.
13. An apparatus according to clause 12 wherein the stage mark is transmissive and the illuminator is configured to illuminate the stage mark from behind.
14. An apparatus according to clause 12 or 13 wherein the illuminator comprises a light guide, desirably an optical fibre, configured to direct light from a light source to the stage mark.
15. An apparatus according to clause 13 wherein the light source is located off the stage.
16. An apparatus according to any preceding clause further comprising a further stage mark and a further optical system for projecting an image of the further stage mark.
17. An apparatus according to any preceding clause wherein the stage is configured to hold a die or chiplet. as the first substrate.
18. An apparatus according to any preceding clause wherein the support structure is configured to hold a wafer as the second substrate.
19. A stage for a joining apparatus for joining a first substrate to a second substrate, the stage configured to hold the first substrate and comprising
   a stage mark and an optical system for projecting an stage mark image.
20. A stage according to clause 19, wherein the stage:
   is rotatable about an axis;
   defines a plurality of holding planes each for holding a first substrate; and
   has a stage mark and an optical system associated with each holding plane.
21. An alignment method in an apparatus configured to join a first substrate and a second substrate, wherein the apparatus comprises a stage for supporting the first substrate and a support structure for supporting the second substrate, the method comprising:
   projecting a stage mark image to a location substantially coplanar with a joining surface of the first substrate; and
   measuring the relative positions of the stage mark image and one or more substrate marks provided on the first substrate.
22. A calibration method in an apparatus configured to join a first substrate and a second substrate, wherein the apparatus comprises a stage for supporting the first substrate and a support structure for supporting the second substrate, the method comprising:
   projecting a stage mark image to a location substantially coplanar with a joining surface of the first substrate; and
   detecting the stage mark image using an optical sensor on the substrate support.
23. A joining method for joining a first substrate and a second substrate using an apparatus comprising a stage for supporting the first substrate and a support structure for supporting the second substrate, the method comprising
   aligning the first substrate to the stage using the method of clause 20;
   determining the relative position of the stage mark image and the support structure using the method of clause 21; and
   positioning the stage and/or the support structure during a joining process based on results of the aligning and determining.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.
The descriptions above are intended to be illustrative, not limiting. Thus, it will be apparent to one skilled in the art that modifications may be made as described without departing from the scope of the claims set out below.

## Claims

1. A joining apparatus for joining a first substrate to a second substrate, the apparatus comprising:
a stage for holding the first substrate; and
a support structure for supporting the second substrate;
wherein the stage comprises a stage mark and an optical system for projecting an stage mark image.

2. An apparatus according to claim 1 wherein:
the stage defines a holding plane on which the first substrate is supported;
the mark is recessed behind the holding plane; and
the optical system is configured to project the stage mark image to a position in front of the holding plane.

3. An apparatus according to claim 2 wherein the distance between the holding plane and the stage mark image is in the range of from about 0.2 mm to about 5 mm, desirably about 0.5 mm to about 1.5 mm.

4. An apparatus according to claim 1, 2 or 3 further comprising an alignment system configured to measure the relative positions of the stage mark image and one or more substrate marks provided on the first substrate.

5. An apparatus according to claim 1, 2, 3 or 4 further comprising an optical sensor provided on the support structure and configured to detect the stage mark image.

6. An apparatus according to any preceding claim wherein the optical system has a magnification substantially equal to 1.

7. An apparatus according to any preceding claim wherein the optical system is accommodated in the stage behind the holding plane.

8. An apparatus according to any preceding claim wherein the optical system comprises an adjustment mechanism configured to adjust the position of the stage mark image.

9. An apparatus according to any one of claims 1 to 8 wherein the stage mark and the optical system are formed by a reflective hologram.

10. An apparatus according to any one of claims 1 to 8 wherein the stage mark comprises an arrangement of transmissive parts and reflective parts.

11. An apparatus according to any preceding claim further comprising an illuminator configured to illuminate the stage mark.

12. An apparatus according to claim 11 wherein the stage mark is transmissive and the illuminator is configured to illuminate the stage mark from behind.

13. A stage for a joining apparatus for joining a first substrate to a second substrate, the stage configured to hold the first substrate and comprising
a stage mark and an optical system for projecting an stage mark image
wherein the stage:
is rotatable about an axis;
defines a plurality of holding planes each for holding a first substrate; and
has a stage mark and an optical system associated with each holding plane.

14. An alignment method in an apparatus configured to join a first substrate and a second substrate, wherein the apparatus comprises a stage for supporting the first substrate and a support structure for supporting the second substrate, the method comprising:
projecting a stage mark image to a location substantially coplanar with a joining surface of the first substrate; and
measuring the relative positions of the stage mark image and one or more substrate marks provided on the first substrate.

15. A joining method for joining a first substrate and a second substrate using an apparatus comprising a stage for supporting the first substrate and a support structure for supporting the second substrate, the method comprising
aligning the first substrate to the stage using the method of claim 13;
determining the relative position of the stage mark image and the support structure using the method of claim 14; and
positioning the stage and/or the support structure during a joining process based on results of the aligning and determining.
